Europäisches Patentamt

European Patent Office

Office européen des brevets

(11) Numéro de publication : **0 124 423**
**B1**

(12) **FASCICULE DE BREVET EUROPÉEN**

(45) Date de publication du fascicule du brevet :
**12.11.86**

(51) Int. Cl.⁴ : **H 03 F   3/60**

(21) Numéro de dépôt : **84400797.1**

(22) Date de dépôt : **19.04.84**

(54) Amplificateur hyperfréquence de puissance.

(30) Priorité : **29.04.83 FR 8307179**

(43) Date de publication de la demande :
**07.11.84 Bulletin 84/45**

(45) Mention de la délivrance du brevet :
**12.11.86 Bulletin 86/46**

(84) Etats contractants désignés :
**DE GB NL**

(56) Documents cités :
FR-A- 2 362 492
RCA REVIEW, vol. 41, no. 3, septembre 1980, pages 472-503, Princeton, New Jersey, USA; B. DORNAN et al.: "A 4-GHz GaAs FET power amplifier: An advanced transmitter for satellite down-link communication systems"
ELECTRONIQUE INDUSTRIELLE, no. 45, janvier 1983, pages 49,50, Paris, FR; J. JOSEFOWICZ: "Amplificateur de grande puissance à l'état solide 3GHz"
IEEE TRANSACTIONS ON MICROWAVE THEORY AND TECHNIQUES, vol. MTT-29, no. 6, juin 1981, pages 513-534, IEEE, New York, USA; R.A. PUCEL: "Design considerations for monolithic microwave circuits"
L'ONDE ELECTRIQUE, vol. 61, no. 11, novembre 1981, pages 17-23, Paris, FR; H.F. COOKE: "Les transistors à effet de champ micro-ondes"

(73) Titulaire : **THOMSON-CSF**
**173, Boulevard Haussmann**
**F-75379 Paris Cedex 08 (FR)**

(72) Inventeur : **Magarschack, John**
**THOMSON-CSF SCPI 173, bld Haussmann**
**F-75379 Paris Cedex 08 (FR)**
Inventeur : **Pavlidis, Dimitris**
**THOMSON-CSF SCPI 173, bld Haussmann**
**F-75379 Paris Cedex 08 (FR)**

(74) Mandataire : **Taboureau, James et al**
**THOMSON-CSF SCPI 19, avenue de Messine**
**F-75008 Paris (FR)**

## Description

La présente invention concerne une nouvelle structure d'amplificateurs de puissance haute fréquence monolithique, à transistors à effet de champ réalisés dans des matériaux rapides de la famille III. V, tels que par exemple GaAs, GaAlAs, InP... Ces amplificateurs intégrés sont adaptés en entrée et en sortie, et possèdent un grand gain et une forte puissance de sortie.

L'amplificateur haute fréquence selon l'invention existe en une pluralité de réalisation, de géométries différentes, qui toutes ont une même base, le transistor hyperfréquence de petite ou moyenne puissance, doté d'une seule entrée, la grille ou la source mais d'au moins deux sorties, deux drains par exemple. Toutes les réalisations ont également une même structure, selon laquelle une pluralité de transistors à effet de champ élémentaires sont groupés selon une organisation arborescente. Chaque transistor à effet de champ élémentaire peut être adapté à la même impédance en entrée et en sortie ; étant de faible puissance, il est de faibles dimensions géométriques, ce qui permet d'une part d'avoir une faible largeur de grille, d'autre part de ne pas avoir de déphasage important entre les signaux d'entrée et de sortie.

Ainsi chaque transistor à effet de champ constitue le module de base, à une entrée et au moins deux sorties, de chaque étage de l'amplificateur hautes fréquences. Les modules de base sont organisés selon une structure arborescente, c'est-à-dire qu'un transistor d'un étage commande au moins deux transistors de l'étage suivant. Toutes les sorties des transistors du dernier étage sont réunies entre elles pour recueillir sur une sortie unique toute la puissance de l'amplificateur. Outre l'amélioration des caractéristiques électriques citées, c'est-à-dire hautes fréquences de fonctionnement et faibles déphasages, cette structure apporte un meilleur isolement entrée-sortie, même avec un amplificateur à grand gain, et facilite l'implantation géométrique, ce qui est avantageux pour une insertion dans un circuit intégré plus complexe, et ce qui permet d'optimiser la dissipation thermique de l'amplificateur.

De façon plus précise l'invention concerne un amplificateur hyperfréquence de puissance, de réalisation intégrée sur un unique substrat et de structure arborescente comportant une pluralité d'étages d'amplification, montés en série, chaque étage comportant une pluralité de cellules élémentaires d'amplification, montées en parallèle, cet amplificateur étant caractérisé en ce que chaque cellule élémentaire d'amplification possède une borne d'entrée et au moins deux bornes de sortie, chacune des bornes de sortie d'une cellule élémentaire d'un premier étage commandant directement, par une métallisation, la borne d'entrée d'une cellule élémentaire de l'étage suivant, de sorte qu'une cellule d'un premier étage commande directement au moins deux cellules de l'étage suivant, les sorties des cellules du dernier étage étant connectées directement par des métallisations à une unique borne de sortie de l'amplificateur.

L'invention sera mieux comprise par la description de deux exemples de réalisation qui respectent la structure de l'amplificateur selon l'invention, ces descriptions s'appuyant sur les figures jointes en annexe qui représentent :

figure 1 schéma d'un transistor à effet de champ interdigité de puissance, selon l'art connu,

figure 2 schéma d'un amplificateur à transistor à effet de champ cellulaire, selon l'art connu,

figure 3 schéma structurel d'un amplificateur de puissance hyperfréquences, selon l'invention,

figure 4 schéma simplifié d'un transistor à effet de champ constituant un module élémentaire de la structure selon l'invention,

figure 5 première configuration d'un amplificateur de puissance hyperfréquences selon l'invention,

figure 6 seconde configuration d'un amplificateur hyperfréquences de puissance selon l'invention,

figure 7 implantation d'un amplificateur à trois étages, sur un substrat de GaAs, selon l'invention.

Les amplificateurs de puissance hyperfréquence, qui sont fréquemment utilisés dans les télécommunications ou pour des applications de type militaire, utilisent souvent des transistors à effet de champ comme éléments actifs. Parmi d'autres qualités demandées à ces amplificateurs, trois spécifications sont couramment requises :

— adaptation en impédance en entrée et en sortie,

— un grand gain en tension, ou en signal,

— une forte puissance de sortie.

Les réalisations les plus courantes actuellement en électronique solide se font selon la technologie hybride.

Un exemple d'amplificateur hyperfréquence hybride est décrit dans un article paru dans RCA Review, vol. 41, N° 3, Septembre 1980, pages 472-503. Cet amplificateur comporte plusieurs étages montés en cascade, un élément d'amplification d'un étage pilotant deux éléments d'amplification, montés en parallèle, de l'étage suivant. Mais chaque élément d'amplification ne comporte qu'une seule borne de sortie, de sorte que la liaison entre les étages se fait au moyen de coupleurs en microbandes, dits « 3dB ». Or ces coupleurs sont réalisés sur des plaquettes de céramique, comme diélectrique des microbandes, ce qui interdit donc la réalisation en circuit intégré de cet amplificateur.

De façon générale, les réalisations en technologie hybride sont limitées pour plusieurs raisons.

Les impédances de transistors à effet de champ ne sont pas faciles à adapter lorsque l'amplificateur travaille dans une gamme de hautes fréquences, telle que par exemple 5 à 40 GHz. On sait que les lignes de liaison présentent à ces fréquences des impédances, des selfs, des capacités qui naissent de la proximité entre une ligne et une masse, ou de la proximité de deux lignes entre elles, ou encore de la forme adoptée pour une ligne de liaison. Ces difficultés n'existent pas aux plus basses fréquences, c'est-à-dire celles qui se comptent en mégahertz au maximum.

Le gain d'un amplificateur hyperfréquences est limité. Pour augmenter le gain intrinsèque d'un transistor à effet de champ qui constitue l'un des éléments actifs d'un amplificateur hyperfréquences, il faut augmenter la largeur de la grille de ce transistor : l'impédance du transistor diminue, donc il devient plus difficile à adapter, et en outre, l'augmentation de la largeur de la grille entraîne une diminution de la fréquence maximale de fonctionnement du transistor.

La puissance d'un amplificateur hybride est limitée. Pour augmenter la puissance d'un tel amplificateur, il faut augmenter la largeur de grille de chaque transistor constituant cet amplificateur, donc réapparaissent les mêmes problèmes d'adaptation de l'amplificateur hybride. En outre, la puissance intrinsèque d'un amplificateur est limitée par la dissipation thermique et par le claquage électrique possible de chaque transistor s'il est poussé à ses conditions maximales.

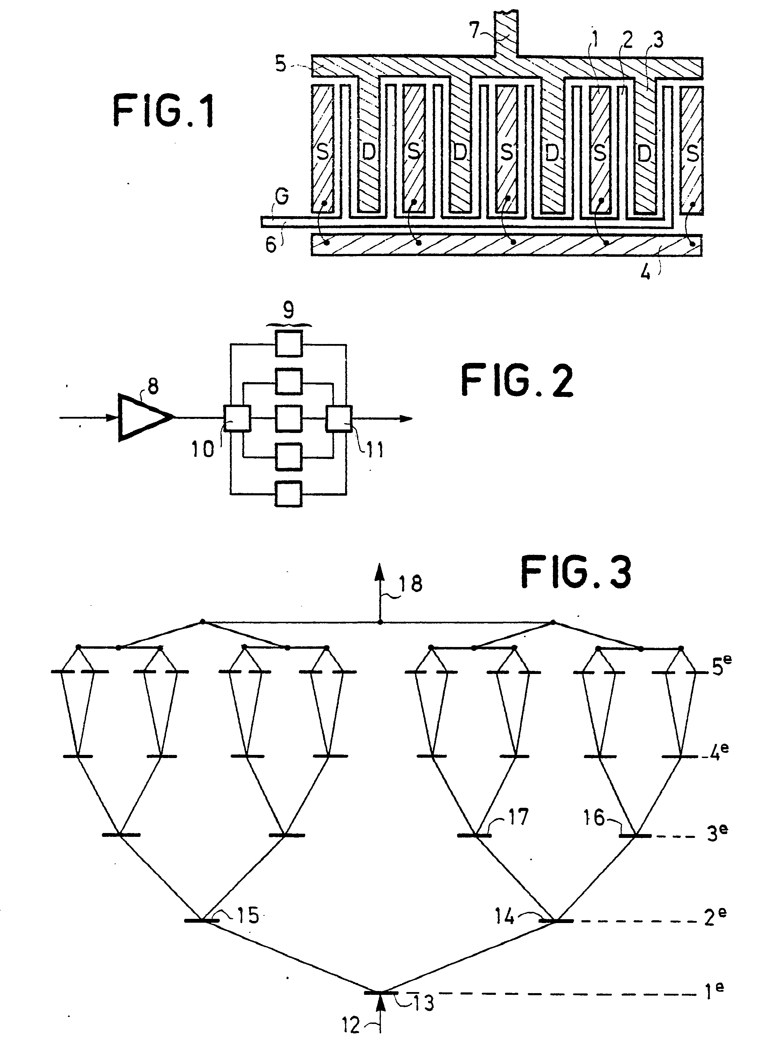

Les figures 1 et 2 représentent deux solutions connues à ce problème d'amplificateur de puissance hyperfréquences : elles peuvent être mises en œuvre soit selon une technologie hybride, soit selon une technologie de circuit intégrés.

La figure 1 représente le schéma de principe d'un transistor de puissance dit interdigité. Ce transistor de puissance est obtenu par la répétition un grand nombre de fois, d'un transistor à effet de champ élémentaire, du niveau d'un transistor de signal, constitué d'une source 1, d'une grille 2 et d'un drain 3. On connaît des transistors interdigités dans lesquels sont regroupés plus de 500 transistors élémentaires tel que celui constitué par la source 1, la grille 2 et le drain 3. Le couplage de ces transistors de signaux élémentaires pour obtenir un transistor de puissance peut se faire soit comme cela est représenté pour les sources sur la figure 1 par des liaisons, par fils, entre chaque plage métallisée de source 1 et une plage métallisée 4 disposée le long du transistor interdigité. Elle peut également se faire comme cela est également représenté pour les drains 3 en prolongeant, au niveau de chaque transistor de signal, la métallisation de drain, toutes les métallisations 3 étant réunies en une métallisation unique 5.

Quel que soit le type de liaison assurée entre les éléments de transistors élémentaires, quelle que soit également la nature de ces transistors ou la géométrie adoptée pour le transistor interdigité, ce qui est important dans cette figure 1 n'est pas la représentation exacte d'un transistor interdigité mais plutôt de permettre de poser le problème de la géométrie des transistors à effet de champ interdigités. Si un tel transistor interdigité est de dimensions importantes, parce qu'il regroupe un grand nombre de transistors à effet de champ élémentaires c'est-à-dire de signaux, en d'autres termes, si sa géométrie est trop large parce que les dimensions des métallisations de source 1 de drain 3 et des bandes de connexion 4 et 5 sont trop grandes aux hautes fréquences par rapport à la longueur d'onde du signal amplifié par ce transistor, il y a des déphasages entre le signal d'entrée et le signal de sortie. En d'autres termes, si un signal, ayant une fréquence propre de quelques GHz, est appliqué sur la grille 6 d'un tel transistor interdigité, et est recueilli sur la métallisation de sortie 7 du drain commun de ce transistor, le chemin parcouru par le signal entre la borne d'entrée et la borne de sortie du transistor n'est pas indifférent : la longueur de chemin est notablement différente à l'échelle de la longueur d'onde du signal selon que celui-ci est transmis par les transistors proches des métallisations d'entrée et de sortie ou est transmis par des transistors éloignés desdites métallisations. Par conséquent, la longueur et la largeur de chaque élément considéré, que ce soit la source ou le drain d'un transistor élémentaire, ou que ce soit la longueur et la largeur du transistor interdigité, interviennent et créent une série de déphasages, chaque transistor élémentaire composant le transistor interdigité ayant son propre déphasage.

La figure 2 représente un autre type d'amplificateur de puissance hyperfréquence connu. C'est un amplificateur dit « cellulaire ».

Le signal hyperfréquence d'entrée est appliqué, dans un amplificateur cellulaire, à un premier organe d'amplification 8, qui est par exemple un amplificateur en tension. Le signal de sortie de cet amplificateur 8, qui n'a pas à être détaillé dans le cas présent, est adressé à un transistor de sortie qui est découpé en cellules adaptées 9. Toutes les cellules 9 sont montées en parallèle et chacune d'entre elles n'a qu'une seule entrée et qu'une seule sortie : on peut dire que chaque cellule 9 constitue un transistor hyperfréquence de moyenne puissance, alliant une optimisation entre les caractéristiques électriques des transistors hyperfréquences de signaux et la puissance qu'il est possible de délivrer sans distorsion ou déphasage. Pour que le signal de sortie de l'amplificateur 8 soit réparti entre les différentes cellules 9, un amplificateur cellulaire comporte des circuits passifs combineurs diviseurs représentés par des blocs diagrammes 10 et 11, le circuit passif 10 répartissant le signal entre les cellules tandis que le circuit passif 11 combine les signaux et la puissance issue des cellules 9.

D'autres types d'amplificateurs de puissance pourraient encore être cités mais il est à remarquer que dans les cas connus le gain en puissance ne se fait généralement que par un seul étage : dans le cas d'un transistor interdigité tel qu'en figure 1, tous les transistors élémentaires sont en parallèle, et ils ont une entrée et une sortie communes. Dans le cas de la figure 2, toutes les cellules sont en parallèle, elles ont également une entrée et une sortie qui sont communes.

La figure 3 représente le schéma structurel d'un amplificateur hyperfréquence selon l'invention.

Pour mettre plus facilement en évidence la structure de cet amplificateur, on conviendra que chaque élément de base ou cellule de l'amplificateur, représenté par un trait ayant une entrée et deux sorties, constitue un transistor à effet de champ : cette représentation éclaire singulièrement le schéma de la figure 3. Le nombre d'étages représentés n'est pas limitatif de l'invention.

L'amplificateur de puissance hyperfréquence représenté en figure 3 comporte 5 étages. Le signal d'entrée, appliqué sur la borne 12 qui est par exemple la grille du premier transistor 13, est amplifié et délivré par deux bornes de sortie du transistor 13 : ces deux bornes de sortie sont par exemple deux drains de ce transistor. Le signal légèrement amplifié en tension et en puissance issu des deux sorties du premier transistor 13 est adressé en parallèle sur les deux bornes d'entrée des deux transistors 14 et 15 qui constituent le second étage de l'amplificateur selon l'invention, en série avec le premier étage.

Les deux transistors 14 et 15 du second étage peuvent être comparables au transistor 13 du premier étage, c'est-à-dire que ce sont des transistors de signaux dotés chacun d'une entrée, une grille, et de deux sorties sur deux drains par exemple. Les signaux amplifiés en tension et en puissance issus du transistor 14 sont à leur tour, et chacun respectivement, adressés sur les deux transistors 16 et 17 constituant la moitié du troisième étage. Et symétriquement pour les signaux issus du transistor 15.

La structure de l'amplificateur hyperfréquence de puissance selon l'invention rassemble donc une pluralité d'étages d'amplification, qui sont notés sur le côté de la figure sous forme du premier, second, troisième... etc. étages, lesquels sont en série. Mais dans chaque étage, les cellules de base, dotées d'une seule entrée et de deux sorties, sont commandées par une cellule de l'étage précédent et commandent au moins deux cellules de l'étage suivant. Puisque les composants actifs pour les amplificateurs hyperfréquences aux fréquences considérées, en GHz, sont essentiellement des transistors à effet de champ, chaque cellule de base de l'amplificateur a comme entrée une grille et comme sortie deux drains, ou deux sources.

Les sorties de tous les transistors du dernier étage de l'amplificateur sont regroupées pour délivrer sur la borne de sortie 18 un signal amplifié en tension et en puissance.

La structure de l'amplificateur selon l'invention rappelle le phénomène d'un photomultiplicateur, dans lequel chaque photon incident donne naissance à au moins une paire de photons qui à leur tour donnent naissance à d'autres paires de photons.

Outre la caractéristique de chaque cellule d'avoir une entrée et au moins deux sorties identiques, chaque cellule est adaptée à la même impédance en entrée et sur chaque sortie. Les liaisons entre les transistors de chaque étage se font par des lignes adaptées telles que par exemple des microbandes dont la longueur et la largeur sont en liaison avec la fréquence de travail, lesquelles lignes microbandes étant elles-mêmes connectées aux grilles des transistors par des capacités adéquates.

L'entrée de l'unique transistor du premier étage constitue l'entrée de l'amplificateur. Les sorties des transistors du dernier étage, c'est-à-dire le cinquième étage sur la figure 3, sont connectées entre elles par des circuits combineurs passifs classiques du genre des circuits Wilkinson, pour délivrer un signal unique.

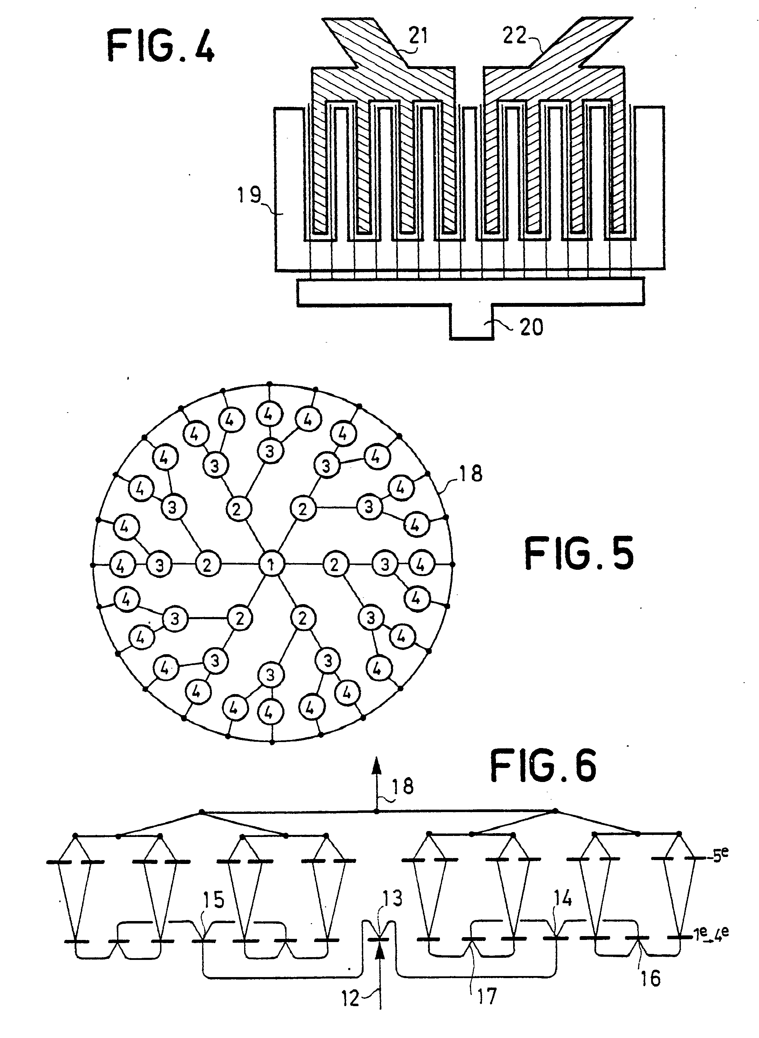

La figure 4 représente une structure, possible parmi d'autres, pour un transistor à effet de champ constituant chacune des cellules de base 13, 14, 15 etc. de la figure 3.

Cette cellule de base est constituée par un transistor à effet de champ interdigité possédant par exemple une source 19, une grille 20 et deux drains 21 et 22.

Le fait que le transistor soit interdigité permet de gagner en puissance à chaque étage mais il est important de remarquer que les transistors interdigités utilisés dans les amplificateurs selon l'invention ne regroupent qu'un faible nombre de transistors élémentaires. Ainsi, sur la figure 4 on voit que chaque drain de sortie correspond à 4 drains de transistors de signal tandis que, comme il a été dit au sujet de la figure 1, les transistors interdigités de puissance regroupent jusque plus de 500 transistors. La différence est importante car le transistor de la figure 4, cellule élémentaire de l'amplificateur selon l'invention, ne regroupant qu'un petit nombre de transistors de signaux, est de petites dimensions : les faibles dimensions font qu'il n'y a pas de déphasage dû à des longueurs géométriques lorsqu'un signal traverse ce transistor.

La cellule élémentaire de la figure 4 comprend également deux circuits d'adaptation en entrée et en sortie qui ne sont pas représentés sur cette figure. Enfin, le fait d'avoir deux drains distincts tels que représentés sur la figure 4 n'est pas indispensable dans le cadre de l'invention : on peut concevoir un transistor interdigité qui ne regrouperait que deux transistors de signaux ou on peut également concevoir que les drains ne soient pas immédiatement réunis par une métallisation 21 ou 22 mais comportent chacun son circuit d'adaptation en impédance. L'important, et cela a été déjà précisé, est que chaque cellule n'a qu'une seule entrée et comporte au moins deux sorties.

Les circuits d'adaptation entre les différents étages de l'amplificateur peuvent être des lignes quart-d'onde simples, par exemple allant de la sortie d'un transistor d'un étage à une entrée d'un autre transistor de l'étage suivant, avec une capacité en série dans la ligne. Elles peuvent être également plus sophistiquées et comporter d'autres éléments tels que les inductances qui optimisent chaque cellule, l'objet final étant de gagner légèrement en tension et en puissance pour chaque cellule élémentaire de façon à obtenir sur la sortie de l'amplificateur un gain important sans distorsion du signal et sans déphasage. Cet objectif est atteint en particulier parce que la multiplication du nombre d'étages d'amplificateurs permet de se contenter d'un faible gain pour chaque étage avec donc une faible contre-réaction du signal de sortie sur le signal d'entrée et donc une faible distorsion ou déphasage.

La figure 3 représente le schéma structurel d'un amplificateur selon l'invention. Dans sa réalisation, l'amplificateur de puissance hyperfréquence peut prendre d'autres formes géométriques d'implantation de chacun des transistors sur une pastille de matériau semiconducteur.

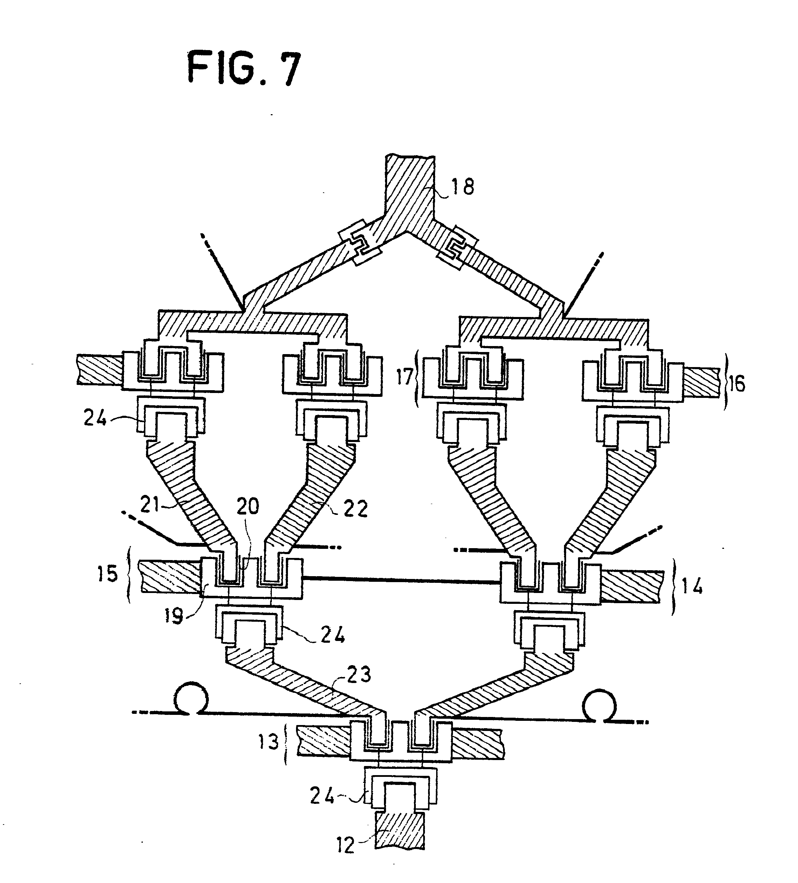

La figure 5 représente un premier exemple de réalisation de l'amplificateur selon l'invention, cette implantation étant concentrique.

Les transistors ou cellules élémentaires de chaque étage sur la figure 5 ne sont pas repérés comme sur la figure 3 par des numéros, 13, 14, 15... etc. mais par le numéro de l'étage de l'amplificateur dont ils font partie. C'est ainsi que l'entrée de l'amplificateur se fait par le transistor central qui constitue le premier étage et qui dans ce cas de figure possède six sorties. Les six sorties du premier transistor alimentent six transistors qui constituent le second étage, chaque transistor repéré 2 ayant à son tour deux sorties qui alimentent chacune un transistor du troisième étage et ainsi de suite. Dans la configuration de la figure 5, l'amplificateur comprend à titre d'exemple quatre étages de transistors élémentaires.

Cette implantation géométrique permet de régulariser la dissipation thermique et par conséquent de conserver des caractéristiques homogènes pour tous les transistors, c'est-à-dire tous les étages de l'amplificateur.

La figure 6 représente une autre configuration d'un amplificateur selon l'invention. Selon cette configuration, les transistors sont implantés selon au moins deux lignes, la première ligne regroupant les premiers, second, troisième et quatrième étages, la seconde ligne regroupant le cinquième étage d'amplification, s'il s'agit d'un amplificateur à cinq étages. De façon plus générale, un amplificateur selon l'invention dans la configuration de la figure 6 comporte au moins deux lignes parallèles de transistors implantés dans la rondelle de matériaux semiconducteurs. Sur la première ligne se trouvent la borne d'entrée 12 et les premiers étages alignés et alternés, l'ensemble des premiers étages étant choisi de telle façon que la somme de tous les transistors soit égale à la somme des transistors du dernier étage moins un ; le dernier étage est quant à lui composé d'une seule ligne de transistors dont les sorties sont réunies pour former une unique sortie 18 de l'amplificateur.

Cette configuration, ou implantation géométrique selon la figure 6 permet de résoudre les problèmes de dimensions car les amplificateurs classiques hybrides ont tendance à être très longs, particulièrement s'il y a un grand nombre d'étages.

Dans cette seconde configuration étant donné que les étages ont été partagés en n-1 étages sur une ligne et le dernier étage sur l'autre ligne, chaque ligne comportant le même nombre de transistors à une unité près, cette configuration permet de régulariser la dissipation thermique, distribuée de façon uniforme.

Un aspect important de l'amplificateur hyperfréquence de puissance selon l'invention est que le problème d'isolation entre l'entrée et la sortie du signal électrique est beaucoup moins important que pour un amplificateur selon l'art connu. En effet, l'amplificateur selon l'invention est constitué d'une pluralité de transistors de signaux à effet de champ, chacun ayant les mêmes caractéristiques que ses voisins. Le gain de chacun de ces transistors de signaux peut être maintenu à un niveau relativement faible de telle sorte que le signal reste relativement constant — à la dispersion de fabrication près — entre chaque point de l'amplificateur ou entre chaque cellule de base. Le niveau de signal restant relativement constant et avec un faible gain pour chaque étage, la réaction du signal de sortie sur le signal d'entrée est faible : par conséquent, il y a peu de déphasages entre les signaux de sortie et les signaux d'entrée. Il est même possible avec la configuration de la figure 6 de connecter les transistors constituant les étages de l'amplificateur de telle façon que les phases soient également très proches, c'est-à-dire que les transistors étant implantés de façon alternée, tête bêche sur une même ligne, les signaux en avance de phase contre-réactionnent les signaux en retard de phase par exemple.

En ce qui concerne le gain total de l'amplificateur, chaque transistor élémentaire peut avoir qu'un faible gain, mais la multiplication de ce faible gain par le nombre d'étages permet d'obtenir, sur la sortie de l'amplificateur considéré dans son ensemble, un signal fortement amplifié en tension et en puissance, sans les limitations dues au déphasage.

En conclusion, on peut dire que dans un amplificateur classique, selon l'art connu, le signal augmente à chaque étage par le gain de l'étage et la taille du transistor augmente avec la hiérarchie des puissances. Par contre, dans la structure selon l'invention, le niveau du signal n'augmente pas beaucoup à chaque étage mais le nombre des points où ce signal est fourni augmente à chaque étage. La structure selon l'invention obtient donc au total une amplification due au nombre de petits transistors de signaux plutôt que due à la puissance d'un petit nombre de transistors de puissance qui, eux, amènent un déphasage. Cet avantage est dû à l'emploi de transistors de signaux ayant chacun une entrée et au moins deux sorties, chaque transistor de signal étant optimisé pour la fréquence de travail.

L'invention a été exposée en s'appuyant sur des figures dans lesquelles les transistors à effet de champ sont schématisés soit par un trait, comme dans les figures 3 et 6, soit par un cercle, comme sur la figure 5. La figure 7 représente un amplificateur selon l'invention, vu au niveau de la surface libre sur une pastille d'un matériau semiconducteur. Cet amplificateur est limité sur la figure 7 à trois étages seulement, ce qui ne limite pas pour autant la portée de l'invention.

On reconnaît sur cette représentation de la partie visible d'un amplificateur selon l'invention, intégré sur GaAs,
— le premier étage, constitué par le transistor 13,
— le second étage, constitué par deux transistors 14 et 15,
— le troisième étage, dont les transistors 16 et 17 forment une moitié.

L'entrée de l'amplificateur se fait en 12 sur la grille du premier transistor 13, et la sortie en 18, sur les drains de tous les transistors du dernier étage.

Chaque transistor comporte une source 19, une grille 20 et deux drains 21 et 22. Les liaisons entre transistors se font par des microbandes quart d'onde 23 et des capacités 24.

Les métallisations d'alimentations et les découplages à la masse ne sont pas représentés sur cette figure.

Etant donné les fréquences de travail de l'amplificateur selon l'invention, les matériaux rapides tels que GaAs, AlGaAs, InP ou d'autres matériaux des familles III.V par exemple sont préférables. Toutefois, ce type d'amplificateur est également applicable à de plus faibles fréquences, sur des matériaux tels que les siliciums.

L'amplificateur selon l'invention est essentiellement utilisé pour les signaux radioélectriques, dans les télécommunications, les radars ou les matériels militaires et spatiaux. Il est destiné à l'intégration monolithique et une configuration telle que celle de la figure 6 permet de l'inclure dans des circuits intégrés plus complexes, comportant entre autres un amplificateur hyperfréquence.

L'invention est précisée par les revendications suivantes.

**Revendications**

1. Amplificateur hyperfréquence de puissance, de réalisation intégrée sur un unique substrat et de structure arborescente comportant une pluralité d'étages d'amplification, montés en série, chaque étage comportant une pluralité de cellules élémentaires (13 à 17) d'amplification, montées en parallèle, cet amplificateur étant caractérisé en ce que chaque cellule élémentaire (13 à 17) d'amplification possède une borne d'entrée (20) et au moins deux bornes de sortie (21, 22), chacune des bornes de sortie (21 ou 22) d'une cellule élémentaire (13 à 17) d'un premier étage commandant directement, par une métallisation (23), la borne d'entrée (20) d'une cellule élémentaire de l'étage suivant, de sorte qu'une cellule d'un premier étage commande directement au moins deux cellules de l'étage suivant, les sorties (21, 22) des cellules du dernier étage étant connectées directement par des métallisations à une unique borne de sortie (18) de l'amplificateur.

2. Amplificateur hyperfréquence selon la revendication 1, caractérisé en ce que les cellules élémentaires d'amplification (13 à 17) sont des transistors à effet de champ, de faible puissance, dont la borne d'entrée (20) est la grille, dont les bornes de sorties, au moins deux (21, 22) sont soit deux drains, soit deux sources, les transistors étant alimentés par celles de leurs électrodes, source ou drain respectivement, qui ne constituent pas leurs électrodes de sorties.

3. Amplificateur hyperfréquence selon la revendication 1, caractérisé en ce que les cellules élémentaires d'amplification (13 à 17) sont des transistors à effet de champ de faible puissance, dont la borne d'entrée (19) est la source, dont les bornes de sorties, au moins deux (21, 22), sont deux drains, la grille étant à la masse, les transistors étant alimentés, à travers des inductances, par leurs drains.

4. Amplificateur hyperfréquence selon la revendication 2, caractérisé en ce que les transistors à effet de champ (13-17) constituant les cellules élémentaires étant des transistors de faible puissance, leurs dimensions géométriques sont petites et le déphasage entre les signaux d'entrée et de sorties, pour chaque transistor, est faible.

5. Amplificateur hyperfréquence selon la revendication 2, caractérisé en ce que tous les transistors des étages constituant l'amplificateur ont les mêmes dimensions, et en ce que le gain en puissance, entre un premier étage et un second étage qui lui succède, est obtenu par au moins le doublement du nombre de transistors du second étage par rapport au premier étage.

6. Amplificateur hyperfréquence selon la revendication 2, caractérisé en ce que les transistors sont adaptés en impédance, en entrée et en sortie, les liaisons entre deux transistors (13, 14) appartenant à deux étages successifs de l'amplificateur se faisant par des microbandes adaptées et par des inductances et des capacités en série entre microbande et entrée du transistor.

7. Amplificateur hyperfréquence selon la revendication 1, caractérisé en ce qu'il est réalisé sur un cristal de matériau semiconducteur, selon la technologie des circuits intégrés.

8. Amplificateur hyperfréquence selon la revendication 7, caractérisé en ce que sa structure d'implantation monolithique est concentrique, le transistor d'entrée constituant le premier étage étant au centre, les transistors des étages suivants étant implantés selon des cercles concentriques autour du transistor d'entrée, le signal de sortie de l'amplificateur étant recueilli sur une métallisation (18) qui entoure le dernier étage d'amplification.

9. Amplificateur hyperfréquence selon la revendication 7, caractérisé en ce que sa structure d'implantation monolithique est linéaire, les transistors des premiers étages (1er au 4ème) étant implantés sur une première ligne, répartis symétriquement par rapport au transistor central d'entrée (13), les transistors du dernier étage (5ème) étant implantés sur une seconde ligne, parallèle à la première, l'entrée (12) de l'amplificateur étant sur le transistor (13) central de la première ligne et la sortie (18) de l'amplificateur prélevée sur une métallisation qui réunit toutes les sorties de tous les transistors de la deuxième ligne.

10. Amplificateur hyperfréquence selon la revendication 9, caractérisé en ce que, parmi les transistors (13-17) des premiers étages (1er au 4ème), les transistors (14) d'un étage sont implantés tête-bêche avec les transistors (16, 17) de l'étage suivant, afin d'annuler les déphasages.

## Claims

1. Hyperfrequency power amplifier of integrated construction on a single substrate and in tree structure comprising a plurality of series connected amplifier stages, each having a plurality of elementary parallel-connected amplifier cells (13 to 17), this amplifier being characterized in that each elementary amplifier cell (13 to 17) comprises an input terminal (20) and at least two output terminals (21, 22), each of the output terminals (21 or 22) of an elementary cell (13 to 17) of a first stage directly controlling via a metallization (23) the input terminal (20) of an elementary cell of the following stage in such a manner that a cell of a first stage directly controls at least two cells of the following stage, the outputs (21, 22) of the cells of the first stage being directly connected via metallizations to a single output terminal (18) of the amplifier.

2. Hyperfrequency amplifier according to claim 1, characterized in that the elementary amplifier cells (13 to 17) are low power field-effect transistors whose input terminal (20) is the gate, and whose at least two output terminals (21, 22) are either two drains or two sources, the transistors being fed via those of their electrodes, source or drain respectively, which do not form their output electrodes.

3. Hyperfrequency amplifier according to claim 1, characterized in that the elementary amplifier cells (13 to 17) are low power field-effect transistors whose input terminal (19) is the source electrode and whose at least two output terminals (21, 22) are two drains, the gate being connected to ground and the transistors being fed via inductances at their drains.

4. Hyperfrequency amplifier according to claim 2, characterized in that the field-effect transistors (13, 17) forming the elementary cells are low power transistors whose geometrical dimensions are small and the phase shifts between the input and output signals for each transistor is small.

5. Hyperfrequency amplifier according to claim 2, characterized in that all the transistors of the stages constituting the amplifier have the same dimensions and that the gain between a first and a second stage following the latter is obtained by at least doubling the number of transistors of the second stage with respect to the first stage.

6. Hyperfrequency amplifier according to claim 2, characterized in that the transistors are adapted in impedance, at the input and outputs, the connections between two transistors (13, 14) belonging to two successive stages of the amplifier being formed by adapted microstrip lines and by inductances and capacitances in series connection between microstrip line and the transistor input.

7. Hyperfrequency amplifier according to claim 1, characterized in that it is formed on a semiconductor crystal in integrated circuit technology.

8. Hyperfrequency amplifier according to claim 7, characterized in that its monolithic implantation structure is concentric, the input transistor forming the first stage lying at the centre and the transistors of the following stages being implanted along concentric circles around the input transistor, the output signal of the amplifier being taken from a metallization (18) surrounding the last amplifier stage.

9. Hyperfrequency amplifier according to claim 7, characterized in that its monolithic implantation structure is linear, the transistors of the first stages (first to fourth) being implanted on a first line distributed symmetrically with respect to the centre input transistor (13), the transistors of the last stage (fifth) being implanted on a second line parallel to the first, the input (12) of the amplifier being formed on the centre transistor (13) of the first line and the output (18) of the amplifier being tapped from a metallization connecting all the outputs of all the transistors of the second line.

10. Hyperfrequency amplifier according to claim 9, characterized in that of the transistors (13 to 17) of the first stages (first to fourth) the transistors (14) of a stage are implanted oppositely orientated to the transistors (16, 17) of the following stage to cancel phase shifts.

## Patentansprüche

1. Leistungs-Höchstfrequenzverstärker, in integrierter Ausführung auf einem einzigen Substrat und in Baumstruktur mit mehreren in Serie geschalteten Verstärkerstufen, von denen jede mehrere elementare parallelgeschaltete Verstärkerzellen (13 bis 17) aufweist, wobei dieser Verstärker dadurch gekennzeichnet ist, daß jede elementare Verstärkerzelle (13 bis 17) einen Eingangsanschluß (20) und wenigstens zwei Ausgangsanschlüsse (21, 22) aufweist, wobei jeder Ausgangsanschluß (21 oder 22) einer elementaren Zelle (13 bis 17) einer ersten Stufe über eine Metallisierung (23) direkt den Eingangsanschluß (20) einer elementaren Zelle der darauffolgenden Stufe ansteuert, so daß eine Zelle einer ersten Stufe wenigstens zwei Zellen der darauffolgenden Stufe direkt ansteuert, wobei die Ausgänge (21, 22) der Zelle der ersten Stufen direkt über Metallisierungen mit einem einzigen Ausgangsanschluß (18) des Verstärkers verbunden sind.

2. Höchstfrequenzverstärker nach Anspruch 1, dadurch gekennzeichnet, daß die elementaren Verstärkerzellen (13 bis 17) Feldeffekttransistoren von geringer Leistung sind, deren Eingangsanschluß (20) das Gate ist, während die wenigstens zwei Ausgangsanschlüsse (21, 22) entweder zwei Drain-Elektroden oder zwei Source-Elektroden sind, und wobei die Transistoren über diejenigen ihrer Elektroden, nämlich Source- oder Drain-Elektrode, gespeist werden, welche nicht ihre Ausgangselektroden bilden.

3. Höchstfrequenzverstärker nach Anspruch 1, dadurch gekennzeichnet, daß die elementaren Verstärkerzellen (13 bis 17) Feldeffekttransistoren von geringer Leistung sind, deren Eingangsanschluß (19) die Source-Elektrode ist, während die wenigstens zwei Ausgangsanschlüsse (21, 22) zwei Drain-Elektroden sind, wobei das Gate an Masse liegt und wobei die Transistoren über Induktivitäten an ihren Drain-Elektroden gespeist werden.

4. Höchstfrequenzverstärker nach Anspruch 2, dadurch gekennzeichnet, daß die Feldeffekttransistoren (13 bis 17), welche die elementaren Zellen bilden, Transistoren von geringer Leistung sind, deren geometrische Abmessungen klein sind, wobei die Phasenverschiebung zwischen den Eingangs- und Ausgangssignalen für jeden Transistor gering ist.

5. Höchstfrequenzverstärker nach Anspruch 2, dadurch gekennzeichnet, daß alle Transistoren der Stufen, welche den Verstärker bilden, dieselben Abmessungen aufweisen und daß die Leistungsverstärkung zwischen einer ersten und einer zweiten, darauffolgenden Stufe durch wenigstens eine Verdoppelung der Anzahl von Transistoren der zweiten Stufe gegenüber der Anzahl der ersten Stufe erhalten wird.

6. Höchstfrequenzverstärker nach Anspruch 2, dadurch gekennzeichnet, daß die Transistoren eingangsseitig und ausgangsseitig impedanzangepaßt sind, wobei die Verbindungen zwischen zwei Transistoren (13, 14), welche zu zwei aufeinanderfolgenden Stufen des Verstärkers gehören, durch angepaßte Mikrostreifenleitungen und durch Induktivitäten und Kapazitäten in Reihenschaltung zwischen Mikrostreifenleitung und dem Transistoreingang ausgeführt sind.

7. Höchstfrequenzverstärker nach Anspruch 1, dadurch gekennzeichnet, daß er auf einem Halbleitermaterialkristall in der Technik integrierter Schaltungen ausgebildet ist.

8. Höchstfrequenzverstärker nach Anspruch 7, dadurch gekennzeichnet, daß seine monolithische Implantationsstruktur konzentrisch ist, wobei der die erste Stufe bildende Eingangstransistor in der Mitte liegt, während die Transistoren der darauffolgenden Stufen längs konzentrischen Kreisen um den Eingangstransistor implantiert sind, wobei das Ausgangssignal des Verstärkers an einer Metallisierung (18) abgenommen wird, welche die letzte Verstärkerstufe umgibt.

9. Höchstfrequenzverstärker nach Anspruch 7, dadurch gekennzeichnet, daß seine monolithische Implantationsstruktur linear ist, wobei die Transistoren der ersten Stufen (erste bis vierte) auf einer ersten Linie implantiert sowie symmetrisch bezüglich des mittleren Eingangstransistors (13) verteilt sind, wobei die Transistoren der letzten Stufe (fünfte) auf einer zweiten, zur ersten parallelen Linie implantiert sind, wobei ferner der Eingang (12) des Verstärkers am mittleren Transistor (13) der ersten Linie gebildet ist und der Ausgang (18) des Verstärkers an einer Metallisierung abgegriffen wird, welche alle Ausgänge aller Transistoren der zweiten Linie verbindet.

10. Höchstfrequenzverstärker nach Anspruch 9, dadurch gekennzeichnet, daß unter den Transistoren (13 bis 17) der ersten Stufen (erste bis vierte) die Transistoren (14) einer Stufe entgegengesetzt orientiert zu den Transistoren (16, 17) der darauffolgenden Stufe implantiert sind, um die Phasenverschiebungen zu annulieren.

# FIG.1

# FIG.2

# FIG.3

# FIG.4

21

22

19

20

# FIG.5

18

# FIG.6

18

5e

15

13

14

1e 4e

12

17

16

2

# FIG. 7